# EUROPEAN PATENT SPECIFICATION

(11) **EP 1 341 275 B1**
(45) Date of publication and mention of the grant of the patent: **26.08.2009**
(21) Application number: 03075441.0
(22) Date of filing: 14.02.2003
(51) Int. Cl.: H01S 5/022, H01S 5/024

(54) **Laser module**
Lasermodul
Module laser

(30) Priority: 18.02.2002 ES 200200378
(43) Date of publication of application: 03.09.2003
(73) Proprietor: Monocrom, 08800 Vilanova I La Geltru, Barcelona (ES)
(72) Inventor: Galan Valiente, Miguel, 08800 Vilanova I La Geltru, Barcelona (ES)
(74) Representative: Thurgood, Alexander John

(56) References cited:
- US-A- 5 978 396
- US-A- 6 151 341
- US-B1- 6 245 589

## Description

### OBJECT OF THE INVENTION

This invention relates to a laser module, of the type that has laser chips connected electrically to electrodes, while the latter can be provided with internal conduits for the circulation of a cooling fluid.

### BACKGROUND OF THE INVENTION

In some of the laser modules currently known in the art, the laser chips are mounted on at least one of the electrodes by soldering, which poses various problems.

The main problem posed is that the laser chip must be placed with very high precision, in such a way that its end projects eight to ten micrometres from the end of the electrode, so that the soldered connection which will join it to said electrode does not reach epitaxy, for if it does so the laser module will be defective.

At present, in order to position the laser chip correctly in relation to the electrodes and their soldered connection with acceptable precision it is necessary to have available micro-robots and other high-precision appliances, which calls for a very considerable investment and thus has a marked effect on the end price of the product.

The soldered connection of the laser chip does not permit subsequent adjustment of its position or replacement of the chip in the event of failure. At present, if the chips have been positioned incorrectly or if they have failed the entire laser module has to be replaced, with the consequent losses.

Another problem currently encountered arises due to the different expansion coefficients of the laser chip and of the material used in the soldered connection. This difference results in the possibility of alterations in the laser chip, usually in its refractive index.

Patent document US 5978396 describes a semiconductor laser source including a stack of semiconductor laser diodes each including at least one active region. The active region includes a series of semiconductor layers located between an ohmic contact layer and a substrate which also assumes the function of an ohmic contact layer. Pressure keeps the diodes in contact with one another by way of their ohmic contact layers. Each diode has dimensions, especially in their thickness, so that the transient heating in each diode is as small as possible and so that the average heating the stackable diodes does not exceed a predetermined value.

Patent Document US6151341 describes a stackable integrated diode packaging in which a stacking of configured laser elements is proposed to absorb heat given out by said laser elements, for their repair and / or replacement, and testing. The assembly includes cells, having a cavity for the passage of coolant there through to cool the laser elements. The cells may be constructed individually for individual testing and then stacked together and removably secured for easy replacement. The cavities of the cells form a substantially contiguous cavity through which the coolant flows into and out the entire assembly. The cavities of the cells include regions and surfaces that improve the flow of coolant to regions substantially adjacent to the laser elements for the cooling thereof.

Patent document US6245589 describes a fabrication of cooling device of a planar light source, including a cooling device of a laser diode array using a stacking of a plurality of metal plate elements, formed with a branched groove pattern or openings, acting as a cooling water path of said laser diodes.

### DESCRIPTION OF THE INVENTION

The laser module of the invention has been designed to solve the aforesaid problems, in that it has constructional features directed at providing solder-free assembly, ensuring correct parallelism and functionality of the laser chips that make it up and a reduction of manufacturing costs due to it not requiring the use of micro-robots for making soldered connections.

The laser module of the invention is of the type which has two or more laser chips connected electrically to some electrodes, which last can have internal conduits for circulation of a cooling fluid.

In accordance with the invention, the module comprises: some electrodes facing each other and connected in alternating order with opposite electrical poles; insulating separators placed between the facing surfaces of the electrodes to prevent direct contact between them and their short-circuiting; laser chips mounted between the facing surfaces of said electrodes, making contact with the electrodes, and tightening means for bringing the electrodes facing each other more closely together to ensure their contact with the laser chips positioned between them, thereby ensuring electrical power supply to the aforesaid laser chips.

The insulating separators have a surface area which is slightly smaller than the facing surface areas of the electrodes, leaving between the latter a free end zone of sufficient size for fitting of the laser chips in contact with the aforesaid electrodes.

Provision is also made for the insulating separators to be of a thickness greater than that of the laser chips and to have the necessary elasticity to permit their compression under the thrust provided by the tightening means, so that said separators can reach a thickness the same as that of the laser chips, which on the one hand permits mechanical securing of the chips by the electrodes and on the other hand electrical contact between the electrodes and the laser chips.

Optionally, at the supporting zone of the laser chips the electrodes can have a layer, coating, film or surface treatment of a material of high electrical and thermal conductivity in order to ensure effective electrical contact between the electrodes and the chips, as well as dissipation of the heat generated.

The mechanical securing of the laser chips by means of the pressure exerted upon them by the electrodes allows the soldered connections to be eliminated, while at the same time providing correct attachment and electrical connection of the laser chips.

Optionally, the tightening means for fixing the various parts of the laser module are composed of screws mounted in some through-holes which run through the electrodes and the insulating separators, and of the corresponding nuts, with the heads of the screws and the nuts bearing upon the exterior surface of the end electrodes of the laser module.

This laser module presents significant manufacturing advantages over those previously known, the most notable advantages being: elimination of the soldered connections and the need to use micro-robots to make them, elimination of the problems posed by the use of materials with different expansion coefficients; the possibility of fitting the laser chips without their projecting from the outline of the electrodes, so that they are better protected; the possibility of mounting several laser chips on a single module, ensuring parallelism between the beams generated by them, and the possibility of correcting the position of the laser chips included in the module, or even replacing them.

### DESCRIPTION OF THE FIGURES

In order to complement this description and facilitate an understanding of the characteristics of the invention, this specification is accompanied by a set of drawings which, with illustrative and non-restrictive character, show the following:
- Figure 1 is a side view of an example of embodiment of the laser module, sectioned along a vertical plane, in which the parts making it up have been shown schematically and disassembled.
- Figure 2 is a side view of an example of embodiment of the assembled laser module sectioned along a vertical plane. In this case the electrodes have interior channels for the circulation of a cooling fluid.

### PREFERRED EMBODIMENT OF THE INVENTION

In the example of embodiment shown in the figures described, the laser module has some electrodes (11, 12 and 13) superimposed and made of a copper alloy of high thermal and electrical conductivity; the two end electrodes (11, 13) are connected to a single electrical pole, while the electrode (12) placed between the former two is connected to the other electrical pole.

Between the electrodes (11, 12 and 13) are some insulating separators (21, 22) whose surface area is slightly smaller than that of the electrodes (11, 12 and 13), and two laser chips (31, 32) which are placed between the facing sides of the aforesaid electrodes, more specifically coinciding with the end zones thereof not reached by the insulating separators (21, 22), thus ensuring contact of each one of the chips (31, 32) with two electrodes (11, 12) and (12 ,13) of different polarity.

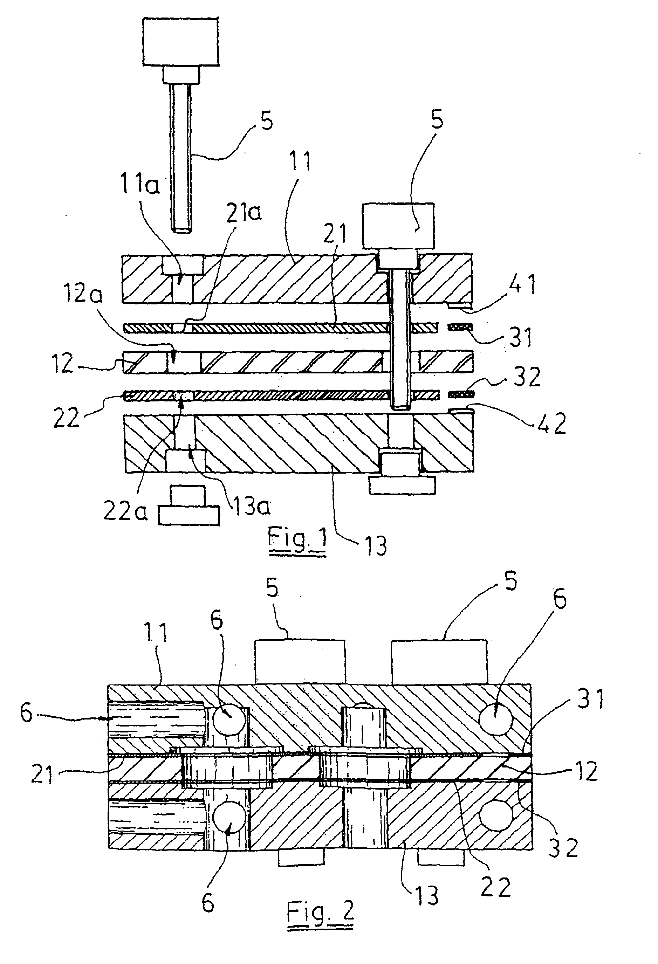

As Figure 1 shows, the electrodes (11, 13) can have in the zone of contact with the laser chips (31, 32) a layer, coating,film or surface treatment (41, 42) of material of high electrical and thermal conductivity. The layers (41, 42) can be composed, for example, of a combination of gold and diamond, since gold has high electrical conductivity and diamond has high thermal conductivity, which facilitates dissipation of the heat produced.

Fixing of the insulating separators (21, 22) and of the laser chips (31, 32) between the electrodes (11, 12 and 13) is implemented by tightening means composed of some screws (51) of conductive material which, in the example of embodiment shown, have the function of interconnecting the electrodes (11, 13) electrically, and by the corresponding nuts (52).

The screws (51) are mounted in some orifices (11a, 12a and 13a) provided in the electrodes (11, 12 and 13).

In order to prevent the screws (51) making contact in the assembled position with the electrode (12) which occupies the intermediate position, provision has been made for the latter to have through-orifices (12a) whose diameter is larger than that of the aforesaid screws (51).

The insulating separators (21, 22) will be made of an elastic material, preferably silicone, and also have orifices (21a, 22a) for passage of the screws (51).

The insulating separators (21, 22) are of a thickness greater than that of the laser chips (31, 32) which means that they can be compressed when the screws (51) are tightened in order to ensure contact of the electrodes (11, 12) and (12, 13) with the laser chips (31, 32) placed between the latter

As Figure 2 shows, the electrodes (11, 12 and 13) can have internal conduits (6) for the circulation of a cooling fluid such as water.

The nature of the invention having been sufficiently described, together with an example of preferred embodiment, it is set on record for the appropriate purposes that the materials, shape, size and arrangement of the elements described may be modified, as long as this does not involve alteration of the essential characteristics of the invention which are claimed below.

## Claims

1. Laser module, of the type that has at least two laser chips each connected electrically to two electrodes, while said electrodes can be provided with internal conduits (6) for the circulation of a cooling fluid; including : some electrodes (11, 12 and 13) facing each other and connected in alternating order with opposite poles; insulating separators (21, 22) placed between the facing surfaces of the electrodes (11, 12 and 13) to prevent direct contact between the electrodes and their short-circuiting; the insulating separators (21, 22) having a surface area which is slightly smaller than the facing surface areas of the electrodes (11, 12 and 13), leaving between the latter a free end zone of sufficient size for fitting of the laser chips (31, 32) in contact with the aforesaid electrodes, whereby the laser chips (31, 32) are mounted, between the facing surfaces of said electrodes (11, 12 and 13) in said free end zone, making contact with the electrodes, and tightening means for bringing the electrodes (11, 12 and 13) facing each other more closely together to ensure their contact with the laser chips (31, 32) positioned between them, thereby ensuring electrical power supply to the aforesaid laser chips and dissipation of the heat generated, whereby the laser module includes a stack of at least three said electrodes (11, 12 and 13), with adjacent electrodes facing each other and connected in alternating order with opposite poles, whereby an insulating separator (21, 22) and a laser chip are placed between each adjacent pair of facing sides of said electrodes, and whereby the insulating separators (21, 22), when not under compression by said fightening means, are of a thickness greater than that of the laser chips (31, 32) and are made of a material of the necessary elasticity to permit their compression by said fightening means down to a thickness equal to that of the laser chips (31, 32).

2. Laser module, according to Claim 1,
**characterised in that** the electrodes (11, 12 and 13) can optionally have, at the supporting zone of the laser chips (31, 32), a layer, coating,film or surface treatment (41, 42) of a material of high electrical and thermal conductivity.

3. Laser module, according to Claim 1,
**characterised in that** the tightening means for fixing the various parts of the laser module are composed of screws (51) mounted in some through-orifices (11a, 12a, 13a, 21a, 22a) which run through the electrodes and the insulating separators, and of the corresponding nuts (52), with the heads of the screws (51) and the nuts (52) bearing upon the exterior surface of the electrodes (11, 13) which occupy the end positions of the stack.

## Patentansprüche

1. Lasermodul mit mindestens zwei Laserchips, die jeweils elektrisch an zwei Elektroden angeschlossen sind, wobei besagte Elektroden mit internen Leitungen (6) zur Zirkulation einer Kühlflüssigkeit ausgestattet werden können, bestehend aus: gegenüberliegenden Elektroden (11, 12 und 13), die in abwechselnder Reihenfolge an die Gegenpole angeschlossen sind; Isoliertrennstücken (12, 22), die zwischen den Oberflächen der Elektroden (11, 12, 13) positioniert sind, um einen direkten Kontakt zwischen den Elektroden und ihrer Kurzschließung zu vermeiden; wobei die Isoliertrennstücke (21, 22) einen Oberflächenbereich aufweisen, der geringfügig kleiner als die Oberflächen der Elektroden (11, 12 und 13) sind, wodurch zwischen diesen eine ausreichend große freie Endzone zum Einfügen der Laserchips (31, 32) in Kontakt mit o.g. Elektroden bleibt, wobei die Laserchips (31, 32) zwischen den Oberflächen besagter Elektroden (11, 12 und 13) in besagter freier Endzone montiert werden und mit den Elektroden einen Kontakt herstellen; des weiteren Fixiervorrichtungen, um die gegenüberliegenden Elektroden (11, 12 und 13) näher aneinander zu bringen, um den Kontakt zwischen ihnen und den dazwischen positionierten Laserchips (31, 32) sicher zu stellen und somit die Stromversorgung o.g. Laserchips sowie die Ableitung der erzeugten Wärme zu gewährleisten, wobei das Lasermodul einen Stapel aus mindestens drei besagten Elektroden (11, 12 und 13) umfasst, und die nebeneinander liegenden Elektroden aufeinander gerichtet und in abwechselnder Reihenfolge an die Gegenpole angeschlossen sind, wobei ein Isoliertrennstück (21, 22) und ein Laserchip zwischen jedes benachbarte Paar aufeinander gerichteter Seiten besagter Elektroden positioniert werden und die Isoliertrennstücke (21, 22), wenn sie nicht von besagter Fixiervorrichtung komprimiert werden, eine größere Dicke als die Laserchips (32, 32) aufweisen und aus einem Material mit der nötigen Elastizität hergestellt sind, um ihre Kompression durch besagte Fixiervorrichtung auf eine Dicke gleich jener der Laserchips (31, 32) zu ermöglichen.

2. Lasermodul nach Anspruch 1, das sich **dadurch** auszeichnet, dass die Elektroden (11, 12 und 13) wahlweise auf dem Trägerbereich des Laserchips (31, 32) eine Schicht, einen Beschichtungsfilm oder eine Oberflächenbehandlung (41, 42) aus einem Material mit hoher elektrischer und thermischer Leitfähigkeit aufweisen können.

3. Lasermodul nach Anspruch 1, das sich **dadurch** auszeichnet, dass die Fixiervorrichtungen zur Befestigung der verschiedenen Teile des Lasermoduls aus in einer Reihe von Durchgangsöffnungen (11a, 12a, 13a, 21a, 22a), die durch die Elektroden und Isoliertrennstücke führen, montierten Schrauben (51) sowie den entsprechenden Muttern (52) bestehen, wobei die Schraubenköpfe (51) und Muttern (52) die Außenfläche der Elektroden (11, 13) abstützen, welche die Endpositionen des Stapels einnehmen.

## Revendications

1. Module laser, du type de ceux qui présentent au moins deux puces laser chacune connectée électriquement à deux électrodes, lesdites électrodes pouvant disposer de conduits internes (6) pour la circulation d'un liquide de refroidissement; comprenant: des électrodes (11, 12 et 13) situées l'une en face de l'autre et connectées en ordre alterné aux pôles opposés, des séparateurs isolants (21, 22) disposés entre les surfaces en regard des électrodes (11, 12 et 13) pour éviter le contact direct entre les électrodes et leur court-circuit; les séparateurs isolants (21, 22) présentant une zone de surface légèrement plus petite que les zones de surface en regard des électrodes (11, 12 et 13) laissant entre les dernières une zone d'extrémité libre, d'une largeur suffisante pour le positionnement des puces laser (31, 32) en contact avec ces électrodes, dans lequel les puces laser (31, 32) sont montées entre les surfaces en regard desdites électrodes (11, 12 et 13) dans ladite zone d'extrémité libre, faisant contact avec les électrodes ; et des moyens de serrage servant à établir le rapprochement des électrodes (11, 12 et 13) situées l'une en face de l'autre afin d'assurer le contact avec les puces laser (31, 32) placées entre elles, assurant ainsi l'alimentation en énergie électrique de ces puces laser et la dissipation de la chaleur produite, où le module laser comprend une pile composée d'au moins trois desdites électrodes (11, 12 et 13) avec des électrodes adjacentes situées l'une en face de l'autre et connectées en ordre alterné aux pôles opposés, dans lequel un séparateur isolant (21,22) et une puce laser sont placés entre chacune des paires adjacentes des côtés en regard desdites électrodes, et dans lequel les séparateurs isolants (21, 22), lorsqu'ils ne sont pas sous la compression exercée par lesdits moyens de serrage, présentent une épaisseur plus grande que celle des puces laser (31, 32) et sont fabriqués d'un matériau qui présente l'élasticité nécessaire pour permettre leur compression par lesdits moyens de serrage jusqu'à une épaisseur qui équivaut à celle des puces laser (31, 32).

2. Module laser selon la revendication 1, **caractérisé en ce que** les électrodes (11, 12 et 13) peuvent présenter optionnellement, dans la zone d'appui des puces laser (31, 32), une couche, revêtement, film ou traitement de surface (41, 42) d'un matériau à haute conductivité électrique et thermique.

3. Module laser selon la revendication 1, **caractérisé en ce que** les moyens de serrage pour la fixation des différentes parties du module laser sont composés de vis (51) montées sur des orifices traversants (11 a, 12a, 13a, 21 a, 22 bis) qui traversent les électrodes et les séparateurs isolants (52), et des écrous (52) correspondants, les têtes des vis (51) et les écrous (52) agissant sur la surface extérieure des électrodes (11, 13) qui occupent les positions extrêmes de la pile.
